Europäisches Patentamt

European Patent Office

Office européen des brevets

(11) Publication number: **0 367 578**
**A1**

# EUROPEAN PATENT APPLICATION

(21) Application number: **89311266.4**

(51) Int. Cl.5: **G05F 3/28**

(22) Date of filing: **31.10.89**

(30) Priority: **31.10.88 US 264630**

(43) Date of publication of application:
**09.05.90 Bulletin 90/19**

(84) Designated Contracting States:
**DE FR GB IT**

(71) Applicant: **TELEDYNE INDUSTRIES, INC.**
**1300 Terra Bella Avenue**
**Mountain View California 94039(US)**

(72) Inventor: **Yan, Raymond Chan-Man**
**189 Serra Vista Avenue**
**Daly City California 94015(US)**

(74) Representative: **Tomlinson, Kerry John et al**
**Frank B. Dehn & Co. European Patent**
**Attorneys Imperial House 15-19 Kingsway**
**London WC2B 6UZ(GB)**

(54) CMOS compatible bandgap voltage reference.

(57) In a circuit for providing a bandgap voltage reference, a first current ($I_2$) proportional to the thermal voltage $V_T$ is generated by a first current source (1). By means of current mirror operation, the first current induces a second current source (2) to generate a proportional second current ($I_3$). The second current source is coupled to means (322) which generates a first voltage which is proportional to the base-emitter junction of a bipolar transistor. The second current generates a second voltage which is then added to the first voltage to give the voltage reference ($V_{REF}$).

FIG._1

## CMOS COMPATIBLE BANDGAP VOLTAGE REFERENCE

The present invention generally relates to a bandgap voltage reference and is particularly applicable to a CMOS bandgap voltage reference circuit capable of providing a bandgap voltage reference with respect to ground.

The accurate operation of many integrated circuits, such as analog-to-digital converters, depends upon the ability of these circuits to reference a constant voltage. Therefore, any factors affecting the stability of the reference voltage would have an adverse effect upon the proper operation of these circuits. Since temperature variations are a common cause of voltage fluctuations in electrical circuits, there is therefore a need for a circuit that provides a substantially temperature-stable reference voltage.

The temperature stability of a bandgap reference voltage is commonly known in the art. A discussion of bandgap reference voltage circuits is found in "Analysis and Design of Analog Integrated Circuits" by P.R. Gray et al, John Wiley & Sons, 1977, at pages 254-261. Basically, a bandgap reference voltage, $V_{REF}$, is provided by a weighted sum, $V_{REF} = aV_{BE} + bV_T$, where $V_{BE}$ is the base-emitter junction voltage of a bipolar junction transistor, and $V_T$ is the thermal voltage $kR/q$. Typically, $V_T$ is obtained from the difference, $\Delta V_{BE}$, between the base-emitter junction voltages of two bipolar transistors. Because the temperature coefficients of $V_{BE}$ and $V_T$ have opposite signs, therefore, with proper weighting factors a and b, the sum $aV_{BE} + bV_T$, or the sum $aV_{BE} + c\Delta V_{BE}$, can theoretically be adjusted to have a zero temperature coefficient.

Due to the increasing use of CMOS integrated circuits, there has been a desire for a bandgap reference voltage circuit formed by CMOS processes. One such CMOS bandgap reference voltage circuit is disclosed in U.S. Patent No. 4,588,941, issued to D.A. KERTH on May 13, 1986. Another CMOS bandgap voltage reference circuit is described in "Precision Curvature - Compensated CMOS bandgap reference" by B. Song et al in IEEE Journal of Solid State Circuits, Volume SC-18 No. 6, December 1983, pages 634-643.

The CMOS bandgap reference voltage circuits disclosed by the above-cited references are considered undesirable for several reasons. One of the disadvantages of these prior art circuits is their use of operational amplifiers, which usually increase the complexity and, as a result, the die size, of the circuits. Thus, one object of this invention is to have a circuit whereby a bandgap reference voltage is provided without the use of operational amplifiers.

Also, when implemented by P-well CMOS technology, the prior art circuits typically provide the reference voltage with respect to a power supply voltage (for example, $V_{DD}$) rather than with respect to ground. Because power supply voltages are more susceptible to noise, therefore another object of this invention is to have a CMOS circuit whereby the bandgap reference voltage can be provided with respect to ground.

The above identified objects are satisfied by the bandgap voltage reference circuit of the present invention which comprises a first current source and a second current source. The first current source operates to generate a first current whose temperature coefficient is proportional to that of the difference, $\Delta V_{BE}$, between the junction voltages of two bipolar junction transistors. By means of current mirror operation, the first current induces the second current source to generate a second current proportional to the first current. As a result, the temperature coefficient of the second current is also proportional to that of $\Delta V_{BE}$. The second current passes through means whereby a proportional first voltage is generated. Thus, the temperature coefficient of the first voltage is also proportional to that of $\Delta V_{BE}$. The second current source is coupled to means for providing a second voltage whose temperature coefficient is proportional to $V_{BE}$. The first voltage and the second voltage are then summed to give a reference voltage.

Because the first voltage is generated from a current source, it can be easily made to reference ground potential.

As illustrated in the preferred embodiment of the present invention, the bandgap reference voltage is generated in accordance with the present invention without the use of operational amplifiers, therefore, the complexity of the circuit is greatly reduced.

These and other attendant advantages of the present invention will become apparent from the following detailed description of exemplary embodiments and by referenced to the accompanying drawings.

### BRIEF DESCRIPTION OF THE DRAWINGS

Fig. 1 is a schematic circuit diagram illustrating an embodiment of the present invention.

Fig. 2 is a schematic circuit diagram illustrating an embodiment of the present invention with provision to accommodate power supply variations.

Fig. 3 illustrates how the level of a bandgap reference output can optionally be shifted.

Fig. 4 is a cross sectional view of a bipolar transistor used in an embodiment of the present invention.

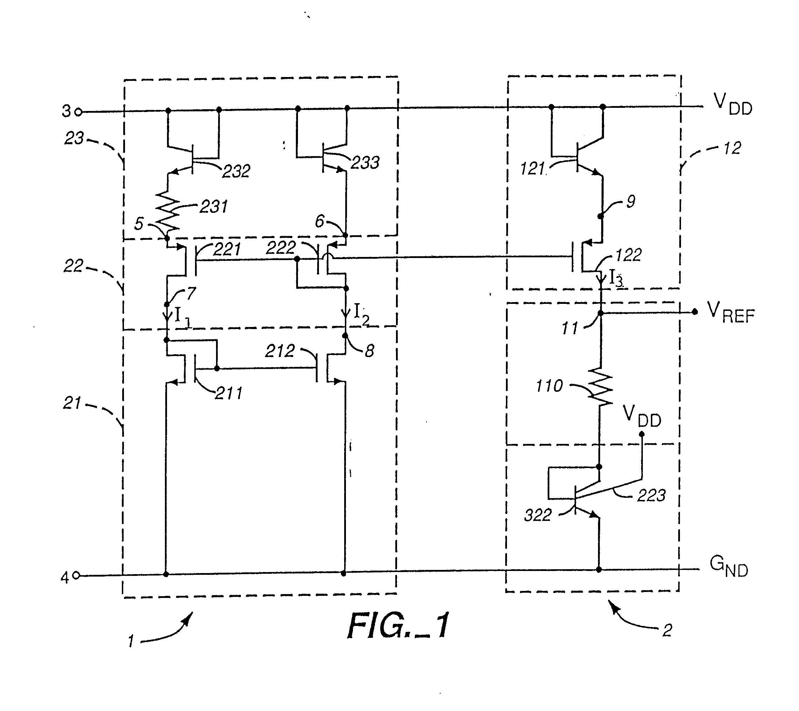

Fig. 1 is a schematic circuit diagram of a circuit embodying the present invention. Fig. 1 shows a block 1 which comprises a first current path $I_1$ coupled to a second current path $I_2$. Current paths $I_1$ and $I_2$ are coupled to a first stage 21, a second stage 22, and a third stage 23.

The first stage 21 is formed by two N-channel FETs 211, 212 connected to provide a current mirror operation between the current paths $I_1$ and $I_2$. Specifically, the gates of FETs 211 and 212 are connected in common to the drain of FET 211. The sources of FETs 211 and 212 are connected in common to the ground (GND) 4. The current mirror operation of the first stage 21 defines a constant ratio between the current $I_1$ and the current $I_2$ so that $I_2$ equals $mI_1$. The ratio, m, between $I_1$ and $I_2$ is defined by the relative width-to-length dimensions between the channel regions of the FETs 211 and 212.

The second stage 22 operates interdependently with the first stage 21. The second stage 22 comprises two P-channel FETs 221, 222. The gates of FETs 221 and 222 are connected in common to the drain of FET 222. The drain of FET 222 is connected to the drain of FET 212. The drain of FET 221 is connected to the drain of FET 211. The second stage 22 establishes the relative potential between a node 5, at the source terminal of FET 221, in current path $I_1$ and a node 6, at the source terminal of FET 222, in current path $I_2$. Given a ratio between $I_1$ and $I_2$ as defined by the first stage 21, the width-to-length dimensions of the channel regions in FETs 221, 222 are adjusted so that the potential at node 5 is equal to the potential at node 6.

The third stage 23 comprises two NPN bipolar transistors 232, 233 and a resistor 231. The collectors and the bases of the bipolar junction transistors 232, 233 are commonly connected to the power supply terminal $V_{DD}$ 3. The emitter of bipolar junction transistor 232 is connected to one end of the resistor 231. The other end of resistor 231 is connected to the source of FET 221. The emitter of bipolar junction transistor 233 is connected to the source of FET 222.

Since the combined operation of stage 1 and stage 2 establishes equal potentials between the source of FET 221 (node 5) and FET 222 (node 6), the potential difference between $V_{DD}$ and node 5 is equal to the potential difference between $V_{DD}$ and node 6. But the potential difference between $V_{DD}$ and node 5 is equal to the base-emitter junction voltage of transistor 232 plus the voltage drop across resistor 231, and the potential difference between $C_{DD}$ and node 6 is equal to the base-emitter junction voltage of transistor 233. Therefore:

$$V_{BE(233)} = V_{BE(232)} + I_1 R_{231}$$
$$V_{BE(233)} - V_{BE(232)} = I_1 R_{231}$$
$$\Delta V_{BE} = I_1 R_{231}$$
$$I_1 = \Delta V_{BE} R_{231} \qquad \text{Eq. (1)}$$

Because, as previously discussed, FETs 211 and 212 operate to maintain $I_2 = mI_1$, therefore, by substituting Eq. (1) into $I_1$:

$$I_2 = m(\Delta V_{BE}) R_{231} \qquad \text{Eq. (2)}$$

Thus, the third stage 23 operates to establish the current value of $I_2$ so that it is proportional to the difference between the base-to-emitter voltages of the two bipolar coefficent of $I_2$ in Eq. (2) is dependent upon the temperature coefficients of $R_{231}$ and $\Delta V_{BE}$.

The circuit of Fig. 1 also shows a second current source 2 having a current path $I_3$ which comprises a diode-connected NPN bipolar junction transistor 121 and a P-channel FET 122. The base and collector of transistor 121 are commonly connected to the power supply terminal 3. The emitter of transistor 121 is connected to the source of FET 122.

The gate of FET 122 is connected to the gates of FETs 211 and 222. The geometries of transistors 121 and 122 are chosen such that their respective current/voltage characteristics are symmetrical and that transistors 121 and 122 mirror transistors 233 and 222 with the voltage at the source of FET 122 being equal to and following the voltage at the source of FET 222. As a result, FET's 122 and 222 operate to provide a current mirror operation between $I_2$ and $I_3$ whereby any current in $I_2$ will induce a proportional current in $I_3$.

Let $I_3 = nI_2$, substitute equation (2) into $I_2$:
$$I_3 = nI_2 = nm(\Delta V_{BE} R_{231})$$

The current in $I_3$ passes through a resistor 110 and generates a voltage equal to $I_3 R_{110}$ thereacross.

Since $I_3 = nm(\Delta V_{BE} R_{231})$, the voltage across resistor 110 is thus equal to $nm \cdot \Delta V_{BE} \cdot (R_{110}/R_{231})$.

Since the temperature dependencies of both $R_{110}$ and $R_{231}$ cancel each other in $R_{110}/R_{231}$, therefore the temperature coefficient of the voltage across resistor 110 is proportional to the temperature coefficient of $\Delta V_{BE}$.

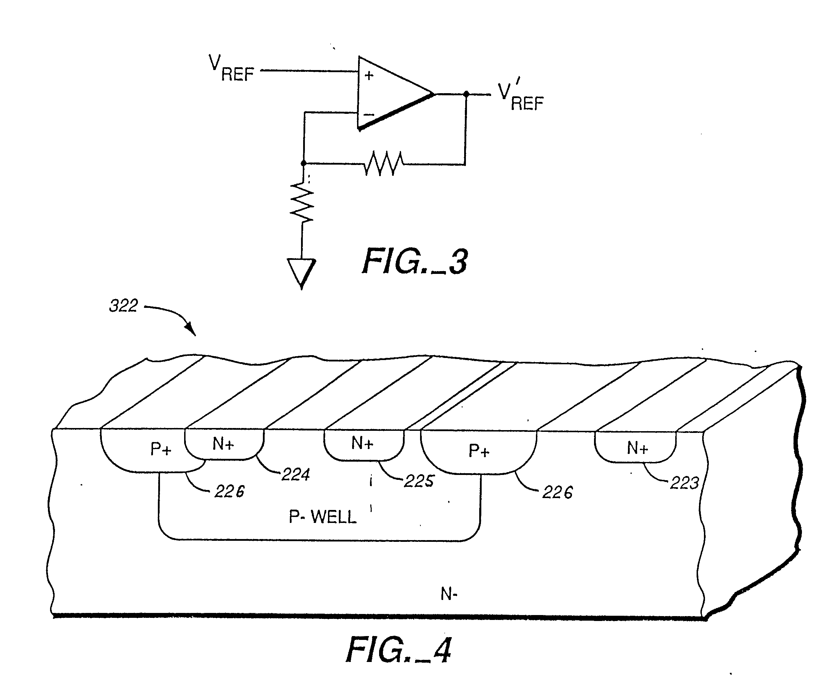

Resistor 110 is connected in series with a diode-connected NPN bipolar transistor 322. Transistor 322 is a lateral bipolar transistor fabricated in P-well technology. A cross-sectional view of the transistor 322 is shown in Fig. 4. The transistor comprises a base region 226 which is connected to the resistor 110, a collector region 225 which is also connected to the resistor 110, and an emitter region 224 which is connected to the ground 4. The substrate of the transistor 322 is connected to

$V_{DD}$ through 223 as required by CMOS technology. With the above connection, the voltage across transistor 322 is equal to its base-to-emitter voltage, $V_{BE}$.

An output voltage, $V_{REF}$, which is taken between ground terminal 4 and the drain of FET 122, is:

$V_{REF} = V_{BE} + nm \cdot \Delta V_{BE} \cdot (R_{110}/R_{231}) = V_{BE} + K \cdot (\Delta V_{BE})$

Thus, $V_{REF}$ gives a bandgap voltage reference. By adjusting the value of K, the temperature coefficient of $R_{REF}$ can be made equal to zero.

In summary, the circuit in block 1 of Fig.1 generates a current $I_2$ whose value is proportional to the difference between respective base-emitter junction voltages of the bipolar transistors 232 and 233. The current $I_2$ induces a proportional current $I_3$ in block 2 through the current mirror operation between transistors 222 and 122. The current $I_3$ produces a voltage drop across resistor 110. This voltage drop is added to the base-emitter junction voltage of lateral bipolar transistor 322 to give the bandgap voltage reference.

When the power supply voltage between $R_{DD}$ 3 and ground 4 increases, the voltage at the drain of FET 212 with respect to $V_{DD}$3 will increase accordingly. When this voltage increases to a certain value, channel length modulation in FET 212 will cause an increase in the current flowing through FET 212 which will then have a finite output impedance characteristic. FET 211, however, is not so affected because its gate is connected to its drain. Therefore, when the power supply voltage between 3 and 4 increases, a mismatch will occur between FET 212 and FET 211 and will cause the ratio between $I_1$ and $I_2$ to increasingly deviate from its preferred value.

Similarly, when the voltage between $V_{DD}$ 3 and ground 4 increases, the voltage between the drain and source of FET 221, and the voltage between the drain and source of FET 122 will increase. When this voltage increases to a certain value, channel length modulation in FETs 221 and 122 will cause an increase in the current flowing through FETs 221 and 122, and FETs 221 and 122 will then have a finite output impedance characteristic. However, the drain of FET 222 is not so affected because its gate and drain are commonly connected. Therefore, when the power supply voltage increases, an increasing mismatch will appear between FETs 221 and 222, and between FETs 122 and 222.

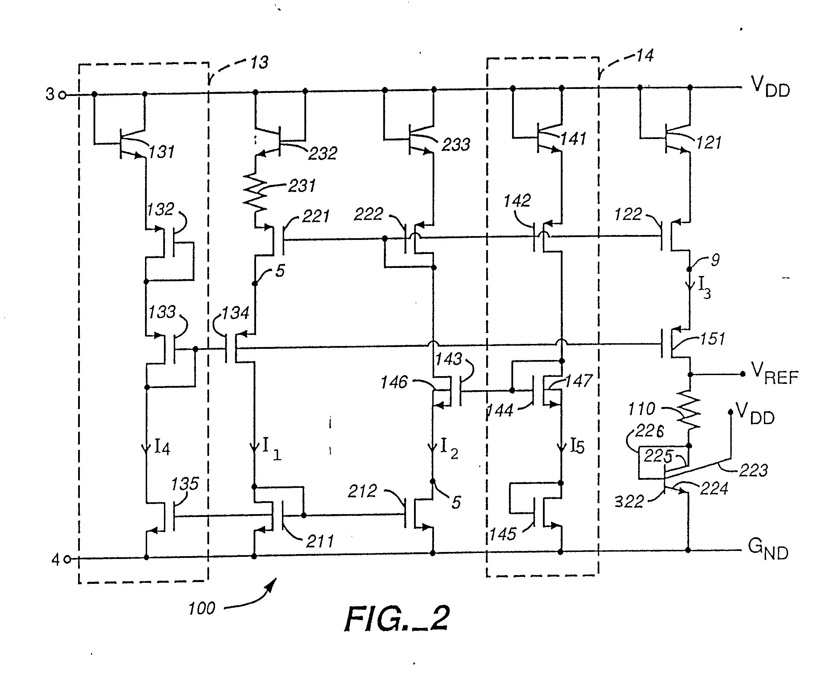

Fig. 2 illustrates an embodiment of the present invention with the addition of circuits 13 and 14 to provide proper operation of the circuit 100 in the presence of power supply voltage variation between terminals 3 and 4.

Circuit 13 comprises an N-channel FET 135, two P-channel FETs 133 and 132, and an NPN bipolar junction transistor 131 which are coupled in series to form a current path 14. Transistors 131 and 132 of circuit 13 mirror transistors 233 and 222 of current path $I_2$. Circuit 13 is coupled to current path $I_1$ by a P-channel FET 134 which is inserted between the drains of FET's 221 and 211. FET 133 is also coupled to a P-channel FET 151 which is inserted between FET 122 and resistive element 110 in current path $I_3$. Circuit 13 sets a lower limit on the voltage at the drain of FET 221 in $I_1$ and at the drain of FET 122 and $I_3$.

Circuit 14 comprises an NPN bipolar junction transistor 141, a P-channel FET 142, an N-channel FET 144 and an N-channel FET 145 which are coupled in series to form a current path $I_5$. Transistor 145 of circuit 14 mirrors transistor 211 of current path $I_1$. The circuit 14 is coupled to $I_2$ by an N-channel FET 143 whose drain is connected to the drain of FET 222 and whose source is connected to the drain of FET 212. The well 146 of FET 143 and the well 147 of FET 144 are respectively connected to their sources. Circuit 14 sets an upper limit on the voltage at the drain of FET 212 in $I_2$.

The voltage at the drain of FET 221 in $I_3$ is:

$V_{DD} - V_{BE(131)} - V_{GS(132)} - V_{GS(133)} + V_{GS(134)}$

Since the gates of FET's 133 and 134 are connected together, the lower limit of the voltage at the source of FET 134 will be clamped by the voltage at the source of FET 133. However, since transistors 131 and 132 mirror transistors 233 and 222, the voltage at the drain of FET 132 is therefore clamped to the voltage at the drain of FET 222.

The voltage at the drain of FET 122 in $I_3$ is:

$V_{DD} - V_{BE(131)} - V_{GS(132)} - V_{GS(133)} + V_{GS(151)}$

Since the gates of FET's 133 and 151 are connected together, the lower limit voltage at the source of FET 151 will be clamped by the voltage at the source of FET 133. However, since transistors 131 and 132 mirror transistors 233 and 222, the voltage at the drain of FET 122 is therefore clamped to the voltage of the drain of FET 222.

The voltage at the drain of FET 212 is:

$V_{GS(145)} + V_{GS(144)} - V_{GS(143)}$

Since the gates of FETs 144 and 143 are connected together, the upper limit of voltage at the drain of FET 212 will be clamped by the voltage at the drain of FET 145. But since transistor 145 mirrors transistor 211, the upper limit of voltage at the drain of FET 212 is therefore clamped to the voltage at the drain of FET 211.

The following parameters are given as an example for implementing the preferred embodiment:

The ratio between the respective emitter areas, A, of bipolar junction transistors 131, 232, 233, 141 and 121 is:

$A_{131} : A_{232} : A_{233} : A_{141} : A_{121} = 1 : 100 : 1 : 1 :$

2

In current path $I_2$:

$FET_{222}$ $(\frac{W}{L})p = \frac{50}{25}$

$FET_{243}$ $(\frac{W}{L})n = \frac{15}{25}$

$FET_{212}$ $(\frac{W}{L})n = \frac{15}{25}$

In current path $I_3$:

$FET_{222}$ $(\frac{W}{L})p = \frac{100}{20}$

$FET_{251}$ $(\frac{W}{L})p = \frac{100}{20}$

In current path $I_1$:

$FET_{221}$ $(\frac{W}{L})p = \frac{50}{25}$

$FET_{234}$ $(\frac{W}{L})p = \frac{15}{25}$

$FET_{211}$ $(\frac{W}{L})n = \frac{15}{25}$

In current path $I_4$:

$FET_{232}$ $(\frac{W}{L})p = \frac{25}{25}$

$FET_{233}$ $(\frac{W}{L})p = \frac{25}{20}$

$FET_{235}$ $(\frac{W}{L})n = \frac{7.5}{20}$

In current path $I_5$

$FET_{242}$ $(\frac{W}{L})p = \frac{25}{25}$

$FET_{244}$ $(\frac{W}{L})n = \frac{7.5}{20}$

$FET_{245}$ $(\frac{W}{L})n = \frac{7.5}{20}$

$R_{231}$ = 12K ohm

$R_{110}$ = 33k ohm

In operation:

$V_{BE(232)} = V_T ln[I_1/I_{s(232)}]$

$V_{BE(233)} = V_T ln[I_2/I_{s(233)}]$

Where $V_T$ = thermal voltage, and

$I_s$ = saturation current which is proportional to the emitter area of a transistor.

$V_{BE(233)} - V_{BE(232)} = V_T ln[(I_2/I_{s(233)})/(I_1/I_{s(232)})]$

Because $FET_{211}(\frac{W}{L}) = FET_{212}(\frac{W}{L})$, therefore $I_2 = I_1$

$\therefore \Delta V_{BE} = V_T ln[I_{s(232)}/I_{s(233)}] = V_T ln[A_{(232)}/A_{(233)}] = V_T ln\ 100 = 120\ mV$

$\therefore I_1 = (\Delta V_{BE}/R_{231}) = 10\mu A$

With the given values of the transistors in the exemplary implementation, a currrent equal to $2I_2$ is mirrored to $I_3$. Therefore:

$V_{REF} = V_{BE} + 2I_2R_{110} = V_{BW} + 2(\Delta V_{BE}/R_{231})R_{110}$
$= V_{BE} + [(2R_{110}/R_{231})(\Delta V_{BE})]$

To find the proper weighting factors for $V_{BE}$ and $\Delta V_{BE}$ respectively so that $V_{REF}$ has zero temperature coefficient, let

$dV_{REF}/dt = 0$

Since

$V_{REF} = V_{BE} + [(2R_{110}/R_{231})(\Delta V_{BE})]$

therefore

$d[2(R_{110}/R_{231})\Delta V_{BE}]/dT + dV_{BE}/dt = 0$

The temperature coefficient of lateral bipolar transistor 322 at room temperature (25 °C) is -2.2mV/°C.

The temperature coefficient of $\Delta V_{BE}$ at room temperature is 0.4 mV/°C, therefore,

$2(R_{110}/R_{231})(0.4) = 2.2$ mV/°C and $R_{110}/R_{231} = 2.75$.

At 25°C temperature with $(R_{110}/R_{231}) = 2.75$:

$V_{REF} = V_{BE} + 2(R_{110}/R_{231}) (\Delta V_{BE}) = .62 + 2(2.75) (120mV) = 1.28V$

It can be seen from the above description and the figures that the voltage reference is provided without the use of an operational amplifier. If, on the other hand, a different reference voltage is needed (for example, $V'_{REF} = 2.16$ volt), then $V_{REF}$ is fed to a non-inverting amplifier as shown in Fig 3. But such level shifting and the corresponding use of the operational amplifier are optional.

The foregoing disclosure and discussion of the present invention provides a broad teaching of the present invention. It is understood that many modifications and variations thereof will be readily apparent to persons of average skill in the art. One such modification is the substitution of PNP for NPN bipolar transistors, P-channel for N-channel transistors and N-channel for P-channel transistors such that the present invention operates from reversed polarity source potentials. It is therefore to be understood that, within the scope of the appended claims, the invention may be practised otherwise than specifically described.

## Claims

1. A circuit for providing a substantially temperature-independent voltage reference, comprising:
a first current source generating a first current which has a first temperature coefficient;
a second current source;
first current mirror means for providing a current mirror operation between the first current source and the second current source to induce the second source to generate a second current proportional to the first current;
first voltage generation means coupled to the second current source for generating a first voltage from the second current;
second voltage generation means coupled to the first voltage generation means for generating a second voltage having a second temperature coefficient, said first and second temperature coefficients having opposite signs; and
voltage referencing means for providing a weighted sum of the second voltage and the first voltage.

2. A circuit as in claim 1, wherein said first current is proportional to the thermal voltage and wherein said second voltage is proportional to the junction voltage of a bipolar transistor.

3. A circuit as in claim 1 or 2, wherein said first current is proportional to a difference between respective junction voltages of two bipolar transistors and wherein said second voltage is proportional to the junction voltage of a bipolar transistor.

4. A circuit as in claim 1, wherein the first current source comprises:
a first current path;
a second current path;
a first means coupled to the first and second current paths for defining a ratio between respective current values thereof;
a second means coupled to the first and second current paths for defining equal a voltage potential of a first node in the first current path and a second node in the second current path; and
a third means coupled to the first and second nodes for defining said first current.

5. A circuit as in claim 4, wherein the first means comprises first and second transistors interconnected to provide a current mirror operation between said first and second current paths.

6. A circuit as in claim 5, wherein the second means comprises third and fourth transistors interconnected to provide a current mirror operation between said first and second current paths.

7. A circuit as in claim 6, wherein the third means comprises a first bipolar junction transistor and a resistor in the first current path, and a second bipolar junction transistor in the second current path, said first bipolar junction transistor and said resistor being connected in series.

8. A circuit as in claim 7, wherein said transistor is coupled to said first node.

9. A circuit as in claim 7 or 8 wherein the first and second transistors are field effect transistors of a first type, and wherein said third and fourth transistors are field effect transistors of a second type.

10. A circuit as in claim 9, wherein the first type of field effect transistors is N-channel type field effect transistors and wherein the second type of field effect transistors is P-channel type field effect transistors.

11. A circuit as in claim 9 or 10, wherein the first and third transistors, the second and fourth transistors are respective pairs of CMOS transistors.

12. A circuit as in claim 9, 10 or 11, wherein said first current is proportional to a difference between respective junction voltages of the first and second bipolar transistors.

13. A circuit as in any preceding claim wherein said second voltage generating means is a lateral bipolar junction transistor.

14. A circuit as in any preceding claim wherein said first voltage generation means comprises a resistor.

15. A circuit as in any preceding claim wherein said voltage referencing means comprises a node interconnected to said first voltage generation means and said second voltage generation means.

16. A circuit for providing a bandgap voltage reference, comprising:
a first current path;
a second current path;
a third current path;
first current mirror means coupled to the first and second current paths for establishing a ratio between respective current values thereof;
second current mirror means coupled to the first, second and third current paths including means for defining equal voltage potentials among a first point in the first current path and a second point in the second current path and a third point in the third current path, and means for providing a current mirror operation between the second and third current paths to establish a ratio between respective current values;
means coupled to the first and second current paths for defining a first current with a first temperature coefficient in the first current path;
means coupled to the third current path for providing a first voltage from current in the third current path;
means coupled to the third current path for providing a second voltage with a second temperature coefficient, wherein said first and second temperature coefficients have opposite signs; and
means for generating a weighted sum of the first and second voltages.

17. A circuit as in claim 16, wherein the first current mirror means comprises a first field effect transistor of a first type connected in the first current path and a second field effect transistor of the first type connected in the second current path.

18. A circuit as in claim 17, wherein said means for defining the first current comprises a first bipolar transistor connected in series with a resistor in the first current path, and a second bipolar transistor connected in the second current path.

19. A circuit as in claim 18, wherein the second current mirror means comprises a third field effect transistor of a second type connected in the first current path, a fourth field effect transisor of the second type connected in the second current path and a fifth field effect transistor of the second type connected in series with a third bipolar transistor in the third current path.

20. The circuit of claim 19, wherein the first type is N-channel type field effect transistors, and the second type is P-channel type field effect transistors.

21. The circuit as in claim 20, wherein each of the first, second, third, fourth and the fifth transistors has a source terminal, a gate terminal and a drain terminal, wherein the gate terminals of both the first and the second transistors are connected to the drain terminal of the first transistor and wherein the gate terminals of both the third and the fourth transistors are connected to the drain terminal of the fourth transistor.

22. A circuit as in any of claims 16 to 21, wherein said means for providing the first voltage comprises a resistor and the means for providing the second voltage comprises a transistor.

23. A circuit of claim 22, wherein said transistor is a lateral bipolar transistor.

24. A circuit of claim 23, wherein said lateral bipolar transistor is an NPN lateral bipolar transistor.

25. A method of providing a substantially temperature-independent voltage reference, comprising the steps of:
generating a first current with a first temperature coefficient;
using current mirror operation to induce a proportional second current from said first current;
generating a proportional first voltage from the second current;
generating a second voltage with a second temperature coefficient where the first and second coefficients have opposite signs; and
generating a weighted sum of the second voltage and the first voltage.

26. A method as in claim 25, wherein said first temperature coefficient is proportional to the temperature coefficient of a difference between respective base-emitter junctions of two bipolar transistors, and wherein said second temperature coefficient is proportional to the temperature coefficient of a base-emitter junction of a bipolar transistor.

*FIG._1*

EP 0 367 578 A1

FIG._2

EP 0 367 578 A1

$V_{REF}$

$V'_{REF}$

+

−

*FIG._3*

322

P+

N+ 224

N+ 225

P+ 226

N+ 223

226

P- WELL

N-

*FIG._4*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4450367 (R.A. WHATLEY)<br>* column 1, line 66 - column 4, line 30; figure 1 * | 1, 3-12, 14, 16-22 | G05F3/28 |
| A | FR-A-2506043 (THOMSON-CSF)<br>* page 1, line 5 - page 2, line 6; figure 1 * | 1, 2, 25 | |
| D,A | US-A-4588941 (D.A. KERTH)<br>* abstract; figure 2 * | 1 | |

|  | TECHNICAL FIELDS SEARCHED (Int. Cl.5) |
|---|---|
|  | G05F |

The present search report has been drawn up for all claims

| Place of search | Date of completion of the search | Examiner |
|---|---|---|
| THE HAGUE | 31 JANUARY 1990 | ZAEGEL B.C. |